# EUROPÄISCHE PATENTSCHRIFT

(11) **EP 0 903 638 B1**
(45) Veröffentlichungstag und Bekanntmachung des Hinweises auf die Patenterteilung: **18.09.2002**
(21) Anmeldenummer: 98115393.5
(22) Anmeldetag: 17.08.1998
(51) Int. Cl.: G03F 7/039, G03F 7/20

(54) **Verfahren zur Herstellung von Mikrostrukturkörpern**
Process for manufacturing microstructured bodies
Procédé pour la formation des corps microstructurés

(30) Priorität: 19.09.1997 DE 19741492
(43) Veröffentlichungstag der Anmeldung: 24.03.1999
(73) Patentinhaber: Steag MicroParts GmbH, 44227 Dortmund (DE)
(72) Erfinder: Reinecke, Holger, Dr., 44229 Dortmund (DE); Kapitzka, Norbert, 44143 Dortmund (DE); Ballhorn, Ralph-Ulrich, 44227 Dortmund (DE); Schäfermeier, Bernhard, 53115 Bonn (DE); Spitzner, Ulrike, 44623 Herne (DE)

(56) Entgegenhaltungen:
- EP-A- 0 375 929
- EP-A- 0 547 419
- EP-A- 0 851 295
- US-A- 4 756 989
- US-A- 5 153 898
- US-A- 5 415 977
- Y. ZHAANG ET AL.: "IGH aspect ratio micromachining Teflon by direct exposure to synchrotron radiation" APPL.PHYS. LETT., Bd. 67, Nr. 6, 7. August 1995, Seiten 872-874, XP000674181
- H. LORENZ ET AL.: "Mechanical Characterization of a New High-Aspect-Ratio Near UV-Photorsist" MICROELECTRONIC ENGINEERING, Bd. 41/42, 1998, Seiten 371--374, XP004111658
- H.LORENZ ET AL.: "High-aspect-ratio, ultrathick, negative-tone photoresist and its application for MEMS" SNSORS AND ACTUATORS A, Bd. 64, Nr. 1, 1998, Seiten 33-39, XP004102135

## Beschreibung

Die Erfindung betrifft ein Verfahren zur Herstellung von Mikrostrukturkörpern mit Strukturtiefen von mehreren Mikrometern bis in den Millimeterbereich, bei Lateralabmessungen im Mikrometerbereich, durch Bestrahlen von Polymeren mit Röntgenstrahlung und nachfolgender Entwicklung mit geeigneten Entwicklermedien.

In der Mikroelektronik hat die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik sowie die Mikrofluidik zu erwähnen sind. Solche Technologien eröffnen in Kombination mit der Mikroelektronik eine unvorstellbare Zahl neuer elektronischer, optischer, biologischer und mechanischer Funktionselemente. Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig wurden klassische Methoden der Feinwerktechnik für die Mikromechanik ertüchtigt und mit entsprechend modifizierten Halbleiterfertigungsmethoden verschmolzen, um so die engen Grenzen der Siliziumplanartechnik verlassen und neue Gestaltungsmöglichkeiten erschließen zu können, die auf einer Vielzahl von Formen und Materialien aufbauen. Diese Forderung wird zum Beispiel im hohen Maße durch das LIGA-Verfahren erfüllt, das aus den Fertigungsschritten Lithographie, Galvanoformung und Abformung aufgebaut und am Kernforschungszentrum Karlsruhe entwickelt worden ist. Der wesentliche Fertigungsschritt des ursprünglichen LIGA-Verfahrens ist die strukturgenaue Bestrahlung des eingesetzten Polymers. Die prinzipielle Durchführbarkeit des LIGA-Verfahrens konnte anhand einfacher Mikrostrukturen mit einem speziell hergestellten Polymethylmethacrylat, im folgenden PMMA genannt, nachgewiesen werden. Darüber hinaus gibt es zahlreiche weitere Kunststoffe, die zur Bestrahlung mit Röntgenstrahlung entwickelt wurden. Insbesondere sind hier das Polyoximethylen (POM) und Polyester, insbesondere Polyglykolide/-laktide (DE - 41 41 352 A1) hervorzuheben.

Der Einsatz des Epoxidresists SU8 für die Strukturierung mittels UV-Lithographie ist in mehreren Veröffentlichungen beschrieben worden. (High-Aspect-Ratio, Ultrathick, Negative-Tone Near-UV Photoresist for MEMS APPLICATIONS: M. Despont, H. Lorenz, N. Fahrin, J. Brügger, P. Renaud and P. Vettiger, Proc. of the 10th IEEE Int'l Workshop on Micro Electro Mechanical Systems (MEMS'97) Jan. 26-30, 1997, Nagoya, Japan; Micromachining applications of a high resolution ultrathick photoresist: Lee, La Bianca, et al., J. Vac. Sci. Technol. B.13(6), Nov/Dec 1995). Weiter werden Epoxidmischungen für die Kapselung von zum Beispiel mikroelektronischen, elektronischen oder optischen Bauteilen eingesetzt (siehe PROTAVIC-Broschüre).

Bei der Herstellung komplexen dreidimensionaler Strukturen mit Strukturtiefen von mehreren Mikrometern bis in den Millimeterbereich nach dem oben genannten LIGA-Verfahren hat sich gezeigt, daß die bestehenden Kunststoffe einen hohen Bestrahlungsaufwand erfordern. Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik unbrauchbare Mikrostrukturkörpern ergeben. Ein weiteres Problem besteht in der aufwendigen Verarbeitbarkeit bestimmter Kunststoffe, insbesondere von Polylaktiden und Polyglykoliden, die durch aufwendige Prägevorgänge, auf Substraten zur Bestrahlung aufgebracht werden müssen.

UV-härtende Lacksysteme können zur Herstellung von Mikrostrukturen eingesetzt werden. Dabei ist allerdings eine Submikrometergenauigkeit, wie sie für optische und fluidische Komponenten oft notwendig ist, aufgrund von Beugungs-, Streu- und Interferenz-Effekten des eingesetzten Lichtes (Wellenlängen 300 nm bis 460 nm) nicht erreichbar, wenn die Schichtdicken im Mikro- und Millimeterbereich liegen.

Aufgabe der Erfindung ist es, ein Polymer zu finden, welches einen geringen Bestrahlungsaufwand bei Bestrahlung mit Synchrotronstrahlung erfordert und unter dem Einfluß von Röntgenstrahlung depolymerisiert oder vernetzt wird und mit speziellen Entwicklern selektiv entfernbar ist. Das Polymere soll ferner eine einfache Probekörperherstellung aufweisen und keine Spannungsrisse und keine Fehlstellen zeigen. Eine weitgehende Kompatibilität mit Halbleiterfertigungsprozessen ist anzustreben.

Gegenstand der vorliegenden Erfindung ist ein Verfahren zur Herstellung von Mikrostrukturkörpern mit Strukturtiefen von 1 bis 10000 Mikrometern durch bildmäßiges Bestrahlen von Polymeren mit Röntgenstrahlung mit einer Elektronenenergie von 1,0 GeV bis 2,7 GeV und Entwickeln des bestrahlten Polymeren durch selektives Auflösen der löslich gewordenen oder löslich gebliebenen Bereiche, das dadurch gekennzeichnet ist, daß als Polymer ein UV- und lichthärtender Epoxidlack eingesetzt wird, dessen Bestrahlung an einem Synchrotron mit speziellen Vorabsorbern zum Beispiel aus Beryllium oder Polyimidfolie mit Bestrahlungszeiten von 1 Minute bis 300 Minuten bei einem mittleren Ringstrom von zum Beispiel 25 mA erfolgt, und Mikrostrukturen mit einem Aspektverhältnis von 5 zu 1 bis 1000 zu 1 hergestellt werden. Als Röntgenstrahlung kann vorzugsweise Synchrotronstrahlung eingesetzt werden. Zur Durchführung des erfindungsgemäßen Verfahrens können die Epoxidlacke durch Pressen, Extrudieren, Prägen, spritzgießen oder Spincoaten auf einen Träger aufgebracht werden. Das Verfahren kann mehrstufig durchgeführt werden.

Überraschenderweise wurde gefunden, daß die aus dem Bereich der Halbleiterfertigung bzw. Kunststoffklebetechnik bekannten lichthärtenden Epoxidlacke durch Röntgenstrahlung strukturierbar sind und die oben genannten Forderungen erfüllen. Die Verwendbarkeit der unter Röntgenlicht aushärtenden Epoxidlacke zur Herstellung von Mikrostrukturkörpern, bei denen es auf ein hohes Aspektverhältnis ankommt, wie dies beispielsweise für das LIGA-Verfahren erforderlich ist, und die sich dabei ergebenden Vorteile waren überraschend und konnten aus den bisher bekannten Druckschriften nicht hergeleitet werden.

Nach dem erfindungsgemäßen Verfahren lassen sich Mikrostrukturkörper mit Strukturtiefen von 1 Mikrometer bis 10 Millimeter herstellen, so daß durch Bestrahlung mit Synchrotronstrahlung und Einwirkung selektiver Entwickler in einer Abtragstiefe von 1 µm bis 10000 µm bei lateralen Abmessungen im Mikrometer- bis in den Submikrometerbereich strukturiert werden kann. Als selektive Entwickler eignen sich organische Lösemittel und alkalische Medien, vorzugsweise zum Beispiel Propylenglykol-monomethylether-acetat (PGMEA), Hydroxidlösung mit Glykolanteilen oder alkoholische Alkalihydroxidlösungen.

Die Bestrahlung erfolgt beim erfindungsgemäßen Verfahren mittels energiereicher paralleler Strahlung aus Röntgenstrahlquellen. Die Wellenlängen dieser Strahlen liegen in einem Bereich von 0,1 nm bis 10 nm, vorzugsweise von 0,1 nm bis 1 nm. Derartige Bestrahlungen können beispielsweise an einem Synchrotron mit speziellen Vorabsorbern zum Beispiel aus Beryllium oder Polyimidfolie (zum Beispiel Kapton der Firma Dupont de Nemours) mit Bestrahlungszeiten von 1 Minute bis 300 Minuten bei einem mittleren Ringstrom von zum Beispiel 25 mA durchgeführt werden.

Der Bestrahlungsaufwand ist abhängig von der Elektronenenergie im Elektronenspeicherring, der vom Synchrotron abgezweigt ist. Im allgemeinen beträgt die Elektronenenergie 1,0 GeV bis 2,7 GeV.

Zur bildmäßigen Bestrahlung werden üblicherweise spezielle Röntgenmasken beispielsweise aus einer Titan-, Beryllium- oder Diamantträgerfolie mit Gold- oder Wolfram-Absorberstrukturen verwendet.

Für das erfindungsgemäße Verfahren eignen sich besonders der Epoxidlack SU8 (vertrieben durch die Firma micro resist technology), oder die flüssigen Photoresists zum Ätzen von Leiterplatten der Firma Lackwerke Peters GmbH, die unter den Produktnamen ELPEMER bekannt geworden sind. Beispiele für weitere einsetzbare Komponenten sind die Schutzlacke der Firma Protex, die unter den Namen PROTAVIC PU und PROTAVIC UV auf dem Markt erhältlich sind.

Zur Herstellung von Mikrostrukturkörpern können Epoxidlacke durch übliche Verfahren wie zum Beispiel durch Pressen, Spritzguß, Extrusion oder Spincoaten bei Temperaturen zwischen 20 °C und 100 °C auf feste Träger, bevorzugt elektrisch leitende Metallträger wie Nickel, Kupfer, Stahl oder Titan, aufgebracht werden. Dabei können gegebenenfalls Haftschichten, Haftlacke oder spezielle Haftvermittler eingesetzt werden. Die Schichtdicke der Epoxidlacke auf den Trägern liegt im allgemeinen zwischen 1 µm und 10.000 µm, vorzugsweise zwischen 10 µm und 1.000 µm, insbesondere zwischen 100 µm und 800 µm.

Nach dem bildmäßigen Bestrahlen wird mit geeigneten Entwicklermedien entwickelt. Als Entwickler können Systeme auf Basis von Alkylglycol-alkylether-alkylmonocarbonsäure-ester der allgemeinen Formel 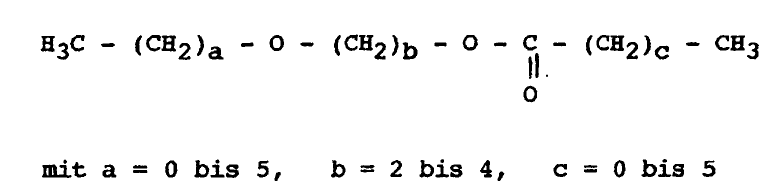 oder deren Isomere, wie Propylenglykol-monomethylether-acetat, Propylenglykol-monoethylether-acetat, Ethylenglykol-butylether-acetat, Butylenglycol-isopropylether-propiat, oder basische Entwickler wie Alkalihydroxidlösungen kombiniert mit Glykolen oder alkoholische Alkalihydroxidlösungen eingesetzt werden.

Das erfindungsgemäß Verfahren hat folgende Vorteile:
- Das eingesetzte Polymer ist mikrostrukturierbar; das Polymer ermöglicht die Herstellung von Mikrostrukturen bis hinab zu einer Strukturbreite von wenigen Mikrometern bei gleichzeitig hohem Aspektverhältnis (Verhältnis von Strukturhöhe zu Strukturbreite) von 5 : 1 bis 1000 : 1, vorzugsweise von 10 : 1 bis 100 : 1.
- Mit den angegebenen Epoxidlacken werden bei gleichem Bestrahlungsaufwand Mikrostrukturen mit wesentlich größeren Strukturtiefen erhalten als mit bekannten Kunststoffen. Im Vergleich zu Polymethyl-methacrylat (PMMA) liegt eine Steigerung der Empfindlichkeit um einen Faktor 100 bis 1000 vor.
- Es lassen sich Strukturen mit Strukturhöhen von zum Beispiel 500 µm bei lateralen Abmessungen im Submikrometer-Bereich herstellen, die keine Defekte aufweisen.
- Es ermöglicht, Strukturgenauigkeiten im Submikrometerbereich zu erzielen.
- Die Mikrostrukturen haben scharfe, steile Kanten und glatte Wände.
- Das Polymer ist bis 80 °C mechanisch stabil und hat eine ausreichende thermomechanische Festigkeit.
- Das Polymer übersteht Galvanikprozesse problemlos und ist beständig gegen zum Beispiel saure Kupfer- und Nickelbäder, Schwefelsäure und Amidoschwefelsäure sowie Komplexbildner. Bei Temperaturen zwischen 20 °C und 80 °C bleiben die Mikrostrukturen über 24 Stunden in den Galvanikbädern unverändert.
- Die Oberfläche des Kunststoffs ist glatt; er läßt sich in gleichmäßiger Schichtdicke auf dem Träger auftragen.
- Die angegebenen Entwickler haben eine sehr gute Selektivität.
- Diese Epoxidlacke sind für den LIGA-Prozeß hervorragend geeignet und auf den in der Halbleitertechnik verwendeten Anlagen sehr gut verarbeitbar.

Das erfindungsgemäße Verfahren wird anhand der folgenden Beispiele näher erläutert, ohne darauf beschränkt zu sein.

### Beispiel 1:

Auf einen Träger mit den Abmessungen 100 mm Durchmesser und 0,5 mm Dicke aus Silizium (Wafer) wurde durch Spincoaten eine Schicht Epoxidlack SU8 von (505 ± 25) µm Schichtdicke aufgetragen. Dieser Resist wurde auf einer Hotplate bei 90 °C getrocknet und danach an einem Synchrotron mit 2,3 GeV Elektronen-Energie 35 Minuten bei einem mittleren Ringstrom von 20 mA und einem Scannerhub von 20 mm bei einer Scannergeschwindigkeit von 1 mm/s durch eine Röntgenmaske mit Teststrukturen (Felder mit sechskantigen Säulen von 1 µm bis 500 µm Durchmesser) bildmäßig bestrahlt. Die Entwicklung fand bei 25 °C mit PGMEA in 25 Minuten statt. Die Struktur war vollständig frei entwickelt. Der strukturierte Epoxidlack ist an typischen Strukturen völlig frei von Entwicklungsresten und zeigt eine hervorragende Entwickelbarkeit von Einzelsäulen bis in den Bereich von 5 µm (Schlüsselweite).

Vergleichsbeispiel 1: Ein Probekörper aus PMMA wurde unter den entsprechenden Bedingungen 60 Minuten bestrahlt und mit dem für PMMA optimierten Entwickler (GG-Entwickler) entwickelt. Der Abtrag betrug nur 100 µm. Bei den entsprechenden Säulenstrukturen war maximal die Säule mit einem Durchmesser von 50 µm vorhanden. Säulen mit kleinerem Durchmesser waren verbogen oder zerstört.

Wie der Vergleich dieser beiden Beispiele zeigt, müssen Strukturhöhen von etwa 500 µm bei PMMA unter gleichen Bedingungen mindestens 10 Stunden bestrahlt werden. Hierbei sind Aspektverhältnisse bis zu 40 erreichbar. Bei SU8 dagegen lassen sich dickere Strukturen bei kürzerer Bestrahlungszeit mit höherem Aspektverhältnis wirtschaftlicher und gleichzeitig mit höherer Qualität herstellen.

### Beispiel 2:

Auf eine Trägerplatte aus Kupfer wurde der Epoxidlack ELPEMER SD 2054 mit einer Dicke von 300 µm durch Spincoaten aufgebracht und an einem Synchrotron mit 2,3 GeV Elektronen-Energie 15 Minuten bei einem mittleren Ringstrom von 20 mA und einem Scannerhub von 20 mm durch eine Röntgenmaske mit Spektrometerstrukturen bildmäßig bestrahlt. Zur nachfolgenden Entwicklung wurde eine fünfprozentige Lösung von Natriumhydroxid in 1 : 1 Wasser/Glykol bei 25 °C und 75 Minuten eingesetzt. Die Struktur war vollständig frei entwickelt. Das strukturierte Epoxid zeigt an den typischen Gitterzähnen der Spektrometerstruktur eine hervorragende Abbildung der funktionsbestimmenden Zahnkanten. Das Spektrometer ist frei von singulären und statistischen Fehlstellen.

Vergleichsbeispiel 2: Ein Probekörper aus PMMA auf Kupfer mit einer Schichtdicke von 300 µm wurde unter den gleichen Bedingungen bestrahlt, bis eine PMMA-typische Bestrahldosis für 300 µm eingelagert wurde. Die Bestrahlzeit betrug 6 Stunden. Die Entwicklung erfolgte mit GG-Entwickler. Bei den Zähnen ergab sich ein Dunkelabtrag sowie eine Verrundung der Strukturen über die ganze Zahnhöhe. Die so erzeugte Struktur weist singuläre und statistische Fehlstellen auf.

Wie der Vergleich dieser beiden Beispiel zeigt, kann die vorgegebene Gitterstruktur für ein Mikrospektrometer mit den typischen Gitterzähnen mit PMMA realisiert werden, wenn erfahrungsgemäß die Mikrostruktur unter 150 µm dick ist. Bei SD 2054 dagegen kann die zu bestrahlende Schicht dicker sein; trotzdem entsteht bei deutlich kürzerer Bestrahlungszeit eine Gitterstruktur mit einwandfreier Zahnform.

## Patentansprüche

1. Verfahren zur Herstellung von Mikrostrukturkörpern mit Strukturtiefen von 1 bis 10000 Mikrometern durch bildmäßiges Bestrahlen von Polymeren mit Röntgenstrahlung mit einer Elektronenenergie von 1,0 GeV bis 2,7 GeV und Entwickeln des bestrahlten Polymeren durch selektives Auflösen der löslich gewordenen oder löslich gebliebenen Bereiche, **dadurch gekennzeichnet, daß**
• als Polymer ein licht- und UV-härtender Epoxidlack eingesetzt wird, dessen Bestrahlung an einem Synchrotron mit speziellen Vorabsorbern zum Beispiel aus Beryllium oder Polyimidfolie mit Bestrahlungszeiten von 1 Minute bis 300 Minuten bei einem mittleren Ringstrom von zum Beispiel 25 mA erfolgt, und
• Mikrostrukturen mit einem Aspektverhältnis von 5 zu 1 bis 1000 zu 1 hergestellt werden.

2. Verfahren nach Anspruch 1, **dadurch gekennzeichnet, daß**
• der Epoxidlack bevorzugt durch Spincoaten oder Spritzguß auf einen Träger aufgebracht wird.

3. Verfahren nach den Anprüchen 1 und 2, **dadurch gekennzeichnet, daß**
• Mikrostrukturkörper mit Strukturtiefen bevorzugt von 10 Mikrometer bis 1000 Mikrometer, besonders bevorzugt von 100 Mikrometer bis 800 Mikrometer, hergestellt werden.

4. Verfahren nach den Ansprüchen 1 bis 3, **dadurch gekennzeichnet, daß**
• Mikrostrukturen mit lateralen Abmessungen bis in den Bereich unter 10 Mikrometer hergestellt werden.

5. Verfahren nach den Ansprüchen 1 bis 4, **dadurch gekennzeichnet, daß**
• Mikrostrukturen mit einem Aspektverhältnis bevorzugt von 10 zu 1 bis 100 zu 1 hergestellt werden.

6. Verfahren nach den Ansprüchen 1 bis 5, **dadurch gekennzeichnet, daß**
• als selektive Entwickler organische Lösemittel, glykolhaltige Alkalihydroxidlösungen oder alkoholische Alkalihydroxidlösungen eingesetzt werden.

7. Verfahren nach den Ansprüchen 1 bis 5, **dadurch gekennzeichnet, daß**
• selektive Entwickler auf der Basis von Alkylglykol-alkylether-alkylmonocarbonsäureester, bevorzugt Propylenglykol-monomethylether-acetat, Ethylenglykol-butylether-acetat, Butylenglykol-isopropylether-propiat, eingesetzt werden.

8. Verfahren nach den Ansprüchen 1 bis 7, **dadurch gekennzeichnet, daß**
• Haftvermittler eingesetzt werden.

## Claims

1. A method of producing a microstructured body with structural depths of from 1 to 10000 micrometres by subjecting a polymer to imagewise irradiation with X-rays with an electron energy of from 1.0 GeV to 2.7 GeV and developing the irradiated polymer by selectively dissolving the regions which have become soluble or have remained soluble, **characterized in that**
• as polymer a photocuring and UV-curing epoxy varnish is used which is irradiated with a synchrotron comprising special preabsorbers of, for example, beryllium or polyimide film for durations of from 1 minute to 300 minutes at an average ring current of, for example, 25 mA, and
• microstructures having an aspect ratio of from 5:1 to 1000:1 are produced.

2. A method according to claim 1, **characterized in that**
• the epoxy varnish is applied to a support preferably by spin coating or injection moulding.

3. A method according to either of claims 1 and 2, **characterized in that**
• microstructured bodies with structural depths of preferably from 10 micrometres to 1000 micrometres, with particular preference from 100 micrometres to 800 micrometres, are produced.

4. A method according to any of claims 1 to 3, **characterized in that**
• microstructures with lateral dimensions down into the range below 10 micrometres are produced.

5. A method according to any of claims 1 to 4, **characterized in that**
• microstructures having an aspect ratio of preferably from 10:1 to 100:1 are produced.

6. A method according to any of claims 1 to 5, **characterized in that**
• organic solvents, glycol-containing alkali metal hydroxide solutions or alcoholic alkali metal hydroxide solutions are used as selective developers.

7. A method according to any of claims 1 to 5, **characterized in that**
• selective developers based on alkyl glycol alkyl ether alkylmonocarboxylic esters, preferably propylene glycol monomethyl ether acetate, ethylene glycol butyl ether acetate, butylene glycol isopropyl ether propionate, are used.

8. A method according to any of claims 1 to 7, **characterized in that**
• adhesion promoters are used.

## Revendications

1. Procédé de fabrication de corps microstructurés présentant des profondeurs de structure allant de 1 à 10.000 microns, en projetant par rayons X une image sur des polymères, avec une énergie des électrons de 1,0 GeV à 2,7 GeV puis en développant le polymère irradié par dissolution sélective des zones devenues ou restées solubles,
**caractérisé en ce qu'**
- on utilise comme polymère une peinture époxyde que l'on irradie au moyen d'un synchrotron avec des pré-absorbeurs par exemple à base de béryllium ou une pellicule de polyimide, avec des temps d'irradiation de 1 à 300 minutes et un courant annulaire de 25 mA par exemple,
- on produit des microstructures avec un rapport d'aspect compris entre 5 pour 1 et 1000 pour 1.

2. Procédé selon la revendication 1,
**caractérisé en ce que**
la peinture époxyde est déposée sur le support par spincoating ou injection.

3. Procédé selon l'une quelconque des revendications 1 et 2,
**caractérisé en ce qu'**
on produit des corps microstructurés avec des profondeurs de structure comprises de préférence entre 10 et 1000 microns, et plus particulièrement entre 100 et 800 microns.

4. Procédé selon l'une quelconque des revendications 1 à 3,
**caractérisé en ce qu'**
on produit des microstructures dont les dimensions latérales descendent jusqu'à moins de 10 microns.

5. Procédé selon l'une quelconque des revendications 1 à 4,
**caractérisé en ce qu'**
on produit des microstructures dont le rapport d'aspect est de préférence compris entre 10 pour 1 et 100 pour 1.

6. Procédé selon l'une quelconque des revendications 1 à 5,
**caractérisé en ce qu'**
on utilise comme développeurs sélectifs des solvants organiques, des solutions d'hydroxydes alcalins à base de glycol ou alcooliques.

7. Procédé selon l'une quelconque des revendications 1 à 5,
**caractérisé en ce qu'**
on utilise des développeurs sélectifs à base d'ester alkylmonocarbonique-d'alkylglycol-alkyléther, de préférence du monométhyléther acétate de propylèneglycol, du butylétheracétate-d'éthylèneglycol, d'isopropyléther-propiate de butylèneglycol.

8. Procédé selon l'une quelconque des revendications 1 à 7,
**caractérisé en ce qu'**
on utilise des agents adhésifs.
